# EUROPEAN PATENT APPLICATION

(11) **EP 3 460 313 A1**
(43) Date of publication of application: **27.03.2019**
(21) Application number: 16913941.7
(22) Date of filing: 27.09.2016
(51) Int. Cl.: F21K 9/232, F21K 9/238, F21K 9/90, F21V 19/00, F21Y 115/10

(54) **LIGHT-EMITTING DIODE BULB HAVING WINDABLE FILAMENT AND MANUFACTURING PROCESS THEREOF**

(30) Priority: 24.08.2016 CN 201610711495
(71) Applicant: Suzhou Industrial Park Hexin Clean Electric Appliance Co., Ltd., Suzhou Industrial Park Suzhou Jiangsu 215122 (CN)
(72) Inventor: HU, Yiwen, Suzhou, Jiangsu 215122 (CN)
(74) Representative: Vitina, Maruta
(86) International application number: PCT/CN2016/100284
(87) International publication number: WO 2018/035921

(57) **Abstract**

Disclosed is an LED lamp with a windable filament and a process for making the same. The LED lamp includes a bulb shell (2), a support (5), an electrical connector (6) and a driver. The support (5) is externally connected to the bulb shell (2), and forms a vacuum sealed cavity with the bulb shell (2). The support (5) is connected to a light bar through an electrical lead wire. The light bar of a strip-shaped structure is provided with a substrate (1). A plurality of connecting circuits (8) are uniformly arranged on the substrate (1). The plurality of connecting circuits (8) are disconnected. An LED chip (9) is provided on the plurality of connecting circuits (8). A fluorescent colloid (10) is provided on the substrate (1). The present invention over the prior art provides an LED lamp with a windable filament and a process for making the same. The special structure of the light bar and the process improve the efficiency and the sensory comfort of the LED lamp.

## Description

### TECHNICAL FIELD

The present invention relates to LED lamps, and more specifically to an LED lamp with a windable filament and a process for making the same.

### BACKGROUND

In the existing technologies of filament lamps and light bars, although a single filament enables global (360°) illumination, many shades (commonly known as ghosts) appear after the lamp is assembled due to the interference of multiple filaments and supports. In the 4π filament technology, the use of a transparent substrate may lead to the leakage of blue light. In addition, the 4π filament process and the substrate processing are complicated with high cost (the chip uses reduced power to improve the luminous efficiency and reduce the temperature).

Chinese Patent Application No. 201510712329.5 discloses a bent filament, where the substrate is produced according to the required pattern; double-sided die bonding is required to ensure that light on both sides of the substrate may emit; and the direction of the substrate is required to be adjusted in the process of die bonding of the arc and the reverse chip. This process is complicated with low yield rate and low efficiency, and one substrate can be only made into one pattern product.

The existing products have poor waterproof and dustproof performances due to the external power supply. The object of the present invention is to solve at least one of the above problems in the prior art.

### TECHNICAL PROBLEMS

To overcome the shortcomings of the prior art, the present invention provides an LED lamp with a windable filament and a process for making the same. The special structure of the light bar and the process improve the efficiency and the sensory comfort of the LED lamp.

### TECHNICAL SOLUTIONS

To achieve the above object, an LED lamp with a windable filament includes a bulb shell, a support, an electrical connector and a driver. The support is externally connected to the bulb shell, and forms a vacuum sealed cavity with the bulb shell. The support is connected to a light bar through an electrical lead wire. The light bar of a strip-shaped structure is provided with a substrate. A plurality of connecting circuits are uniformly arranged on the substrate. The plurality of connecting circuits are disconnected. An LED chip is provided on the plurality of connecting circuits, and a fluorescent colloid is provided on the substrate.

One end of the electrical lead wire is connected to the light bar through an electrode, and the other end of the electrical lead wire is connected to the voltage output end of the driver through a connecting wire. The voltage input end of the driver is connected to the electrical connector, and the electrical connector is provided at the lower end of the support.

The light bar is of a strip-shaped structure formed by a flat plate through die bonding, welding, dispensing and baking and then shaped as required. The shape of the light bar is one of a transverse winding structure, a vertical winding structure, a linear structure, an arc structure, a triangular structure, an elliptical structure, a trapezoidal structure, a square structure, a heart-shaped structure and a diamond-shaped structure.

The vacuum sealed cavity is filled with convective heat-dissipation gas with the thermal expansion coefficient different from the thermal expansion coefficient of air, and the convective heat-dissipation gas is at least one of helium, argon, hydrogen and neon.

The substrate is connected to the LED chip using a flip-chip process or a wire bonding process in an inverted arrangement, and the LED chip is connected to the plurality of connecting circuits through solders.

The substrate of an elongated sheet structure is made from a metal or a flexible circuit board. The thickness of the substrate is less than 0.6 mm, and the width of the substrate is less than 10 mm.

The cross section of the bulb shell has one of a circular shape, a fan shape, an elliptical shape, a triangular shape and a trapezoidal shape.

The LED chip is selected from one of a blue LED chip, a red LED chip, a yellow LED chip, a green LED chip, an ultraviolet LED chip and an infrared LED chip, and is activated by phosphor.

A process for making the LED lamp with a windable filament includes:
(1) fixing the substrate to the light bar;
(2) connecting the LED chip to the substrate using a flip-chip process or a wire bonding process in an inverted arrangement, wherein eutectic soldering, reflow soldering or conductive silver-filled epoxy adhesive is used in the process;
(3) coating the fluorescent colloid on the top of the substrate and the LED chip;
(4) winding the light bar as required;
(5) assembling the light bar, the bulb shell and the support into the lamp; and filling the cavity of the lamp with heat-dissipation protective gas; and
(6) assembling the driver and the electrical connector to manufacture an LED lamp product.

### BENEFICIAL EFFECTS

The present invention over the prior art provides an LED lamp with a windable filament and a process for making the same. The special structure of the light bar and the process improve the efficiency and the sensory comfort of the LED lamp.

### BRIEF DESCRIPTION OF THE DRAWINGS

FIG. 1 is a schematic diagram of an LED lamp with a windable filament of the present invention;
FIG. 2 is a schematic diagram of a light bar;
FIG. 3 is a side view of the light bar; and
FIGS. 4-8 are schematic diagrams of the LED lamp with a windable filament in other embodiments.

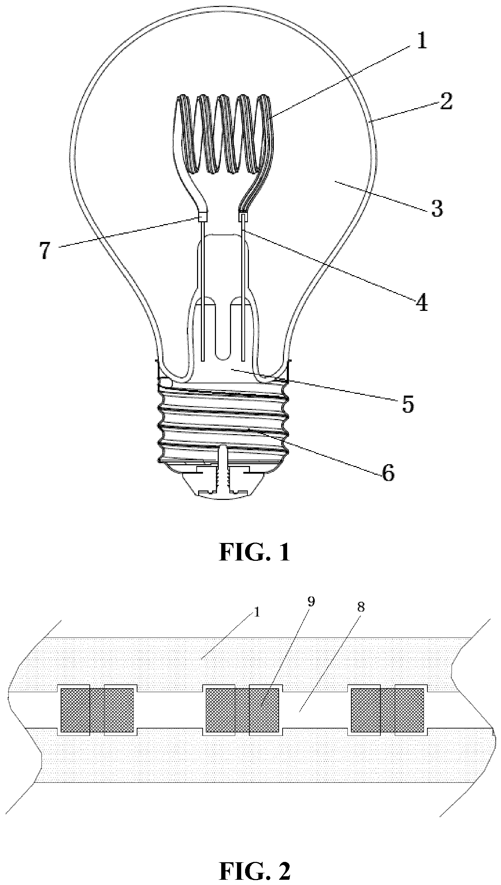

In FIGS. 1-3: 1, substrate; 2, bulb shell; 3, convective heat-dissipation gas; 4, electrical lead wire; 5, support; 6, electrical connector; 7, electrode; 8, connecting circuit; 9, LED chip; 10, fluorescent colloid.

### DETAILED DESCRIPTION OF EMBODIMENTS

The present invention will be further described with reference to the accompanying drawings.

As shown in FIGS. 1-3, a support 5 is externally connected to a bulb shell 2, and forms a vacuum sealed cavity with the bulb shell 2. The support 5 is connected to a light bar through an electrical lead wire 4. The light bar of a strip-shaped structure is provided with a substrate 1. A plurality of connecting circuits 8 are uniformly arranged on the substrate 1. The plurality of connecting circuits 8 are disconnected. An LED chip 9 is provided on the plurality of connecting circuits 8, and a fluorescent colloid 10 is provided on the substrate 1.

One end of the electrical lead wire 4 is connected to the light bar 1 through an electrode 7, and the other end of the electrical lead wire 4 is connected to the voltage output end of the driver through a connecting wire. The voltage input end of the driver is connected to an electrical connector 6, and the electrical connector 6 is provided at the lower end of the support 5.

The vacuum sealed cavity is filled with convective heat-dissipation gas 3 with the thermal expansion coefficient different from that of air, and the convective heat-dissipation gas 3 is at least one of helium, argon, hydrogen and neon.

The substrate 1 is connected to the LED chip 9 using a flip-chip process or a wire bonding process in an inverted arrangement, and the LED chip 9 is connected to the plurality of connecting circuits 8 through solders.

The substrate 1 of an elongated sheet structure is made from a metal or a flexible circuit board. The thickness of the substrate 1 is less than 0.6 mm, and the width of the substrate 1 is less than 10 mm.

The LED chip 9 is selected from one of a blue LED chip, a red LED chip, a yellow LED chip, a green LED chip, an ultraviolet LED chip and an infrared LED chip, and is activated by phosphor.

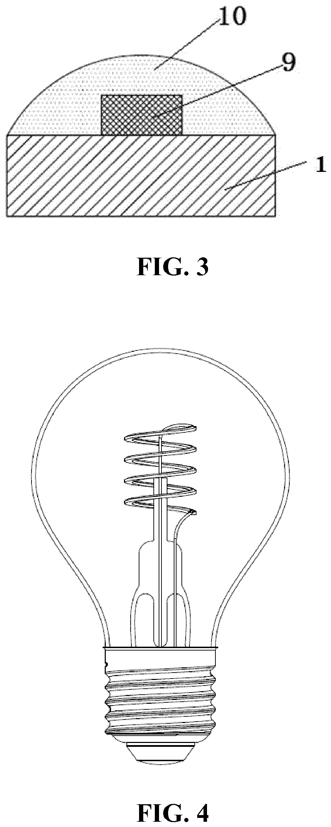

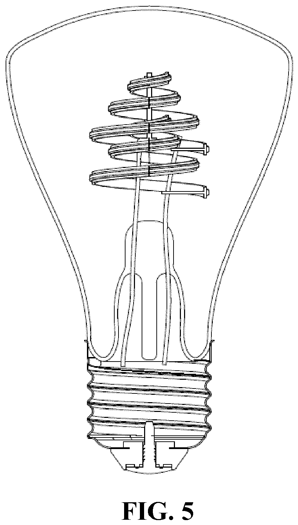

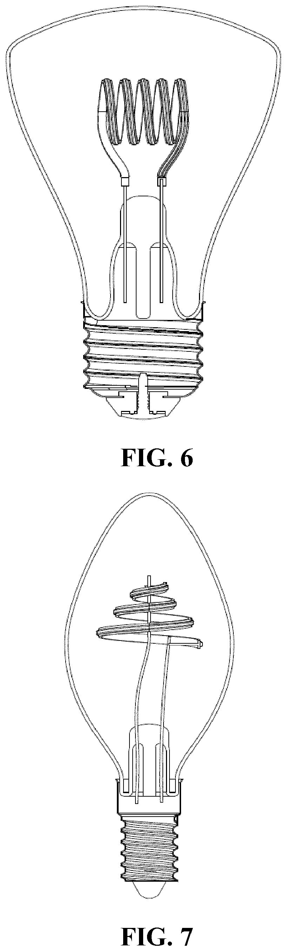

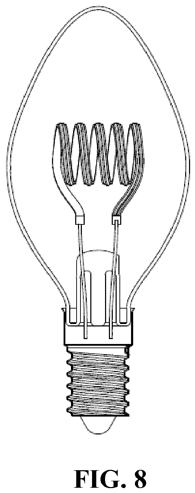

As shown in FIGS. 4-8, the light bar is of a strip-shaped structure formed by a flat plate through die bonding, welding, dispensing and baking and then shaped as required. The shape of the light bar is one of a transverse winding structure, a vertical winding structure, a linear structure, an arc structure, a triangular structure, an elliptical structure, a trapezoidal structure, a square structure, a heart-shaped structure and a diamond-shaped structure. The cross section of the bulb shell 2 has one of a circular shape, a fan shape, an elliptical shape, a triangular shape and a trapezoidal shape.

A process for making the LED lamp with a windable filament includes:
(1) fixing the substrate to the light bar;
(2) connecting the LED chip to the substrate using a flip-chip process or a wire bonding process in an inverted arrangement, wherein eutectic soldering, reflow soldering or conductive silver-filled epoxy adhesive is used in the process;
(3) coating the fluorescent colloid on the top of the substrate and the LED chip;
(4) winding the light bar as required;
(5) assembling the light bar, the bulb shell and the support into the lamp; and filling the cavity of the lamp with heat-dissipation protective gas; and
(6) assembling the driver and the electrical connector to manufacture an LED lamp product.

Because the substrate 1 is in a slit connection, the light bar 1 can be wound into various illuminants with different diameters, lengths and heights, enabling a global (360°) illumination. The support 5 and the bulb shell 2 form a sealed cavity without using the lamp wick, so the cost is reduced. The sealed cavity is filled with the convective heat-dissipation gas 3 with the thermal expansion coefficient different from the thermal expansion coefficient of air. Thus, with the temperature changing in the lamp, the convection is formed in the bulb shell to dissipate heat. The gas flows and circulates in the sealed cavity using the heat generated by the light source and the power supply, thereby taking the heat away. The making process is simple, and the shape, weight and sensitivity of the LED lamp are closest to those of the existing incandescent lamps, improving the efficiency and sensory comfort of the LED lamp.

## Claims

1. An LED lamp with a windable filament, comprising:
a bulb shell,
a support,
an electrical connector, and
a driver,
**characterized in that** the support (5) is externally connected to the bulb shell (2); the support (5) and the bulb shell (2) form a vacuum sealed cavity; the support (5) is connected to a light bar through an electrical lead wire (4); the light bar of a strip-shaped structure is provided with a substrate (1); a plurality of connecting circuits (8) are uniformly arranged on the substrate (1); the plurality of connecting circuits (8) are disconnected; an LED chip (9) is provided on the plurality of connecting circuits (8); and a fluorescent colloid (10) is provided on the substrate (1).

2. The LED lamp according to claim 1, **characterized in that** an end of the electrical lead wire (4) is connected to the light bar (1) through an electrode (7); the other end of the electrical lead wire (4) is connected to a voltage output end of the driver through a connecting wire; a voltage input end of the driver is connected to the electrical connector (6); and the electrical connector (6) is provided at a lower end of the support (5).

3. The LED lamp according to claim 1, **characterized in that** the light bar of a strip-shaped structure is formed by a flat plate through die bonding, welding, dispensing and baking and then shaped as required; and a shape of the light bar is one of a transverse winding structure, a vertical winding structure, a linear structure, an arc structure, a triangular structure, an elliptical structure, a trapezoidal structure, a square structure, a heart-shaped structure and a diamond-shaped structure.

4. The LED lamp according to claim 1, **characterized in that** the vacuum sealed cavity is filled with convective heat-dissipation gas (3) with a thermal expansion coefficient different from a thermal expansion coefficient of air; and the convective heat-dissipation gas (3) is at least one of helium, argon, hydrogen and neon.

5. The LED lamp according to claim 1, **characterized in that** the substrate (1) is connected to the LED chip (9) using a flip-chip process or a wire bonding process in an inverted arrangement; and the LED chip (9) is connected to the plurality of connecting circuits (8) through solders.

6. The LED lamp according to claim 1, **characterized in that** the substrate (1) of an elongated sheet structure is made from a metal or a flexible circuit board; a thickness of the substrate (1) is less than 0.6 mm; and a width of the substrate (1) is less than 10 mm.

7. The LED lamp according to claim 1, **characterized in that** a cross section of the bulb shell (2) has one of a circular shape, a fan shape, an elliptical shape, a triangular shape and a trapezoidal shape.

8. The LED lamp according to claim 1, **characterized in that** the LED chip (9) is selected from one of a blue LED chip, a red LED chip, a yellow LED chip, a green LED chip, an ultraviolet LED chip and an infrared LED chip; and the LED chip (9) is activated by phosphor.

9. A process for making an LED lamp with a windable filament, **characterized by** comprising:
(1) fixing a substrate to a light bar;
(2) connecting an LED chip to the substrate using a flip-chip process or a wire bonding process in an inverted arrangement, wherein eutectic soldering, reflow soldering or conductive silver-filled epoxy adhesive is used in the process;
(3) coating a fluorescent colloid on a top of the substrate and the LED chip;
(4) winding the light bar as required;
(5) assembling the light bar, a bulb shell and a support into the lamp; and filling a cavity of the lamp with convective heat-dissipation gas; and
(6) assembling a driver and an electrical connector to manufacture an LED lamp product.
